# EUROPEAN PATENT APPLICATION

(11) **EP 3 901 649 A1**
(43) Date of publication of application: **27.10.2021**
(21) Application number: 20170277.6
(22) Date of filing: 20.04.2020
(51) Int. Cl.: G01R 33/565

(54) **ARRANGEMENT AND METHOD FOR MOTION CORRECTION IN MAGNETIC RESONANCE IMAGING**

(71) Applicant: Siemens Healthcare GmbH, 91052 Erlangen (DE)
(72) Inventor: Przioda, Daniel, 91054 Erlangen (DE)

(57) **Abstract**

An arrangement (1) for MRI comprises an MRI scanner (2) configured to acquire MR data at an acquisition time (T1), a motion compensation system (4, 5, 6) configured and arranged to determine a position (X1') of an object (8) located in a field of view of the MRI scanner (2) at a recording time and a processing unit (3), configured to generate an MR image based on the MR data and the determined position (X1') to determine a latency period (11) between the recording time and the acquisition time (T1) and to generate the MR image depending on the latency period (11).

## Description

The present invention relates to an arrangement for magnetic resonance imaging, MRI, comprising an MRI scanner, configured to acquire magnetic resonance, MR, data at an acquisition time and a motion compensation system, configured and arranged to determine a position of an object located in a field of view of the MRI scanner at a recording time and a processing unit, configured to generate an MR image based on the MR data and the determined position. The invention further relates to corresponding method and a computer program product.

Object motion during acquisition is one of the most frequent sources of reduced image quality or artifacts in magnetic resonance imaging, MRI. This may for example make it necessary to repeat one or more acquisitions and therefore may lead to an increased total time for the MRI routine. Furthermore, in the context of medical applications, this may lead to additional stress for the patient.

Modern MRI systems implement methods for motion compensation, for example based on navigator recordings, field probes or optical systems, to detect the motion of the object to be imaged. To this end, the motion is tracked and a respective coordinate system for the acquisition may be adapted.

For example, the article J. Maclaren et al.: "Navigator Accuracy Requirements for Prospective Motion Correction", Magnetic Resonance in Medicine 63, 162-170 (2010), presents an analysis linking noise in the tracking system to the power of the resulting image artifacts. The required navigator accuracy is determined based on the properties of the imaged object and the desired resolution.

However, known approaches like this are facing limitations. For example, movements of the object may not be detected completely and therefore may not be fully corrected, in particular in case of fast movements. In fact, for correcting the coordinate system for the acquisition, a position of the object is applied, which may be different from an actual position at the acquisition time. This may lead to wrong layer positions and, consequently, to artifacts in the final image.

It is therefore an object of the present invention to provide an improved concept for magnetic resonance imaging, wherein motion compensation with a higher accuracy is achieved.

This object is achieved by the respective subject-matter of the independent claims. Further implementations and preferred embodiments are subject-matter of the dependent claims.

The improved concept is based on the idea to determine a latency period between a recording time, at which the position of the object is determined and an acquisition time, at which the MR data are actually acquired. The latency period is then explicitly taken into account for generating the MR image, in order to improve the motion compensation.

According to the improved concept, an arrangement for a magnetic resonance imaging, MRI, is provided. The arrangement comprises an MRI scanner, a motion compensation system and a processing unit. The MRI scanner is configured to acquire magnetic resonance, MR, data at an acquisition time. The motion compensation is configured and arranged to determine a position of an object located in a field of view of the MRI scanner at a recording time. The processing unit is configured to generate an MR image based on the MR data and the determined position. The processing unit is further configured to determine a latency period between the recording time and the acquisition time and to generate the MR image based on the MR data and the determined position depending on the latency period.

Therein, the recording time is different from, in particular prior to, the acquisition time.

In particular, the MRI scanner comprises a magnet arrangement for generating a magnet probe field, in particular a homogeneous basic field, at least within the field of view of the MRI scanner.

The MRI scanner may further comprise one or more radio frequency coils for generating excitation pulses in order to excite a nuclear spin ensemble in the object within the field of view of the MRI scanner and to detect MR signals in response to nuclear spin resonance of the excited spin ensemble.

The MRI scanner may further comprise one or more gradient coils for generating magnetic field gradients, in particular for systematically scanning the k-space.

Furthermore, the MRI scanner may comprise a control unit to control the radio frequency coils and the gradient coils, and, if applicable, the magnet arrangement, according to one or more predefined MRI sequences.

The control unit may be fully or partially comprised by the processing unit or may be implemented separately from the processing unit. Alternatively or in addition, the processing unit may perform tasks described with respect to the control unit in the following and vice versa.

The MR data acquired by the MRI scanner may, for example, correspond to one or more MR signals detected by the radio frequency coils or may correspond to data generated based on the MR signals, for example by the control unit.

The MR image corresponds to a two-dimensional image in k-space or in position space or to a plurality of such two-dimensional images, in other words, to a three-dimensional image. In particular, the MR image is reconstructed or generated from the MR data. For example, the MR data may be considered as raw data and the MR image may be considered as a final or intermediate result of the corresponding MRI.

For example, apart from the MR data, the MRI scanner may generate a plurality of sets of further MR data corresponding to different k-space coordinates or different acquisition parameters compared to the MR data. The processing unit may then generate the MR image based on the MR data and the set of further MR data.

The field of view of the MRI scanner corresponds to a three-dimensional spatial region, where the object to be imaged is placed or a part of the object to be imaged is placed.

The motion compensation system, for example one or more cameras of the motion compensation system, may have a further field of view, which overlaps with the field of view of the MRI scanner, such that the object to be imaged is positioned at least in part within the field of view of the motion compensation system.

The object, for which the position is determined, may correspond to the object to be imaged or to a part of the object to be imaged or to an object, for example a marker, attached to the object to be imaged. In particular, the position of the object may correspond to the position of the marker.

The recording time corresponds to a point in time or time stamp, when the object has the determined position or to a point in time or time stamp, when the position is actually determined. The recording time is, in particular, before the acquisition time, which corresponds to a point in time or time stamp, at which the MR data are actually acquired, or to a starting time or time stamp for a corresponding acquisition.

The latency period corresponds to a time period, which has passed between the recording time and the acquisition time.

Therein, the mentioned times, in particular, the acquisition time and the recording time, are measured or determined according to a common clock signal of the arrangement, in particular of the motion compensation system and the processing unit, or according to correspondingly synchronized clock signals.

In order to generate the MR image, the MRI scanner may, for example, acquire a plurality of sets of MR data including the MR data acquired at the acquisition time. The plurality of sets is acquired at different acquisition times. Correspondingly, the position of the object may change between the different acquisition times. Measuring or determining the position of the object, in particular prior to performing the respective acquisition step, allows to adapt a coordinate system for generating the MR image more or less in real time.

Since the arrangement for MRI according to the improved concept is able to take into account the latency period between the recording time and the acquisition time explicitly for generating the MR image, the motion compensation may be carried out with an improved accuracy. This leads to an improved image quality and may avoid wrong layer positions or artifacts. In consequence, unnecessary repetitions are avoided, which leads to a reduced amount of time required for a typical MRI procedure.

The latency period may, for example, result from a time, which is required for detecting the position and transferring the corresponding signals or data from the motion compensation system to the processing unit. Due to this latency, the determined position is, in general, not identical to the position of the object at the acquisition time.

In general, it may for example be ensured that the latency period is smaller than or equal to a maximum latency. In modern MRI systems, the maximum latency may for example lie in the order of 100 ms or below, for example in the order of 50 ms. Nevertheless, in prior art MRI systems, the actual latency period is not determined during or prior to an individual acquisition. According to the improved concept, this deficiency is realized and compensated.

In particular, in order to avoid image artifacts, the accuracy of the position should be five to ten times greater than the resolution of the system. Consequently, considering an exemplary resolution of 1 mm x 1 mm, the tracking accuracy should be better than 0.2 mm. Assuming a latency of 50 ms, a motion of the object with a velocity of 4 mm/s causes a position shift of 0.2 mm during the latency period. However, 4 mm/s corresponds to a very slow motion. For example, the velocity of a human nod may be estimated as approximately 14 mm/s. At the assumed latency of 50 ms, this corresponds to an inaccuracy of 0.7 mm, which is significantly beyond the target of 0.2 mm.

Thus, by taking into account the latency explicitly according to the improved concept, the system accuracy and, in consequence, the image quality, may be improved significantly.

From another point of view, the improved concept may relax the requirements regarding the maximum latency of the system and may therefore reduce overall costs for the arrangement.

According to several implementations, the object comprises a marker, which is detectable by the motion compensation system and determining the position of the object corresponds to or comprises determining a position of the marker.

Here and in the following, a position of the object or the marker may be understood as a relative position with respect to a reference position. The reference position may, for example, be a reference position of the object measured or determined by the motion compensation system. Alternatively, the reference position may be predefined within a coordinate frame of the motion compensation system.

In other words, determining the position of the object at different times may be understood as determining a motion or movement of the object or tracking the position of the object.

The motion compensation system may be implemented separately to the MR scanner. However, the MR scanner may also comprise the motion compensation system in part or completely.

According to several implementations, the processing unit is configured to estimate a compensated position of the object at the acquisition time based on the determined position at the recording time and the latency period. The processing unit is configured to generate the MR image depending on the estimated compensated position and, in particular, based on the MR data and the determined position.

In particular, the processing unit may be configured to adapt a coordinate system for generating the MR data based on the estimated compensated position, in particular instead of doing this based on the determined position at the recording time. By taking into account the compensated position, which can be understood as an approximation to a real position of the object at the acquisition time, an error may be compensated, which would occur in case the determined position would be directly used for adapting the coordinate system without taking into account the latency.

In order to estimate the compensated position based on the determined position, the processing unit may use a position prediction algorithm, which may, for example, be based on a previous motion or movements of the object. The position prediction algorithm may, for example, be based on the calculation of an optical flow of the object or based on other known image processing algorithms and/or computer vision based algorithms.

The processing unit may, for example, extrapolate the determined position to determine the compensated position. For example, the motion compensation system may determine a deviation between the determined position of the object and the reference position and extrapolate the deviation to determine the compensated position.

In particular, the motion compensation system may be configured to continuously track the position of the object and estimate or extrapolate the compensated position based on earlier position data determined by the tracking.

According to several implementations, the MRI scanner is configured to acquire further MR data at a further acquisition time, the motion compensation system is configured to determine a further position of the object at a further recording time and the processing unit is configured to determine a further latency period between the further recording time and the further acquisition time. The processing unit is configured to generate the MR image based on the further MR data depending on the further latency period and, in particular, based on the MR data and the further determined position and, in particular, depending on the latency period.

In particular, the further acquisition time is prior to the acquisition time and the further recording time is prior to the further acquisition time.

The MR data and the further MR data may, for example, correspond to different echoes, pulse trains, segments or excited layers within an MRI sequence and/or to different k-space coordinates.

According to several implementations, the processing unit is configured to estimate a compensated further position of the object at the further acquisition time based on the determined further position at the further recording time and based on the further latency. The processing unit is configured to generate the MR image depending on the estimated compensated further position of the object at the further acquisition time.

According to several implementations, the MRI scanner is configured to acquire a plurality of sets of further MR data at respective further acquisition times and to determine a respective position of the object for each of the acquisitions and a respective further latency period for each of the acquisitions. The processing unit is configured to generate the MR image based on the further sets of MR data.

According to several implementations, the motion compensation system comprises a camera system with a camera field of view, which overlaps at least in part with the field of view of the MRI scanner, wherein the camera system is configured to generate camera data depicting the camera field of view.

In particular, the object is located at least in part within the camera field of view and the camera data depict the object at least in part.

The camera system may comprise one or more cameras. In case of two or more cameras, the cameras may be mounted at different positions of the MRI scanner with respect to the object or the field of view of the MRI scanner. The camera field of view may correspond to a joint field of view of all cameras of the camera system.

By means of the camera system, an exact tracking of the object position is achieved.

According to several implementations, the motion compensation system comprises an image processing unit, which is configured to generate image data based on the camera data, the image data comprising the recording time.
In particular, the image processing unit is configured to determine the recording time, for example based on a respective clock signal of the motion compensation system or the image processing unit, and mark or tag the camera data with the recording time in order to generate the image data.

The image processing unit may be comprised by the camera or may be implemented as a separate piece of hardware.

For example, the image processing unit may comprise a field programmable gate area, FPGA, or a system-on-a-chip, SoC.

The camera data may be considered to represent a raw image of the camera. Since each of the raw images is tagged with a corresponding time stamp representing the recording time, in particular the time when the camera data have been recorded, the recording time may be determined in an accurate manner.

According to several implementations, the motion compensation system comprises a position calculation module, which is configured to generate position data based on the image data, the position data comprising the recording time and the determined position of the object at the recording time.

The position calculation module may be implemented as a separate hardware module, in particular separate to the camera system and the image processing unit. However, the position calculation module may also be a part of the image processing unit and/or the camera system. The position calculation module may, for example, also be implemented as a software module, for example of the image processing unit.

Furthermore, the position calculation module may be configured to utilize further camera output apart from the camera data or the image data, in order to determine the position of object at the recording time, for example, previous camera output.

According to several implementations, the position calculation module is configured to calculate the position of the object at the recording time based on the image data in order to determine the position of the object at the recording time.

According to several implementations, the processing unit is configured to generate the MR image based on the position data, and, in particular, based on the MR data and, in particular, depending on the latency period.

In particular, the processing unit may adapt the respective coordinate frame according to the position data and, in particular, depending on the latency, continuously or at each acquisition in order to generate the MR image with a high accuracy and, in particular, with reduced image artifacts.

According to several implementations, the MRI scanner, in particular the control unit or the processing unit, comprises a first clock generator and the motion compensation system, in particular the image processing unit, comprises a second clock generator. The second clock generator is synchronized to the first clock generator or the first clock generator is synchronized to the second clock generator.

For example, the synchronization of the first and the second clock generator may be carried out prior to the acquisition time and prior to the recording time.

By synchronizing the first and the second clock generator, a higher accuracy of the determined latency period is achieved and therefore the image quality of the MR image is further improved.

In particular, the image processing unit may determine the recording time based on the second clock generator, for example based on a second clock signal generated by the second clock generator.

Furthermore, the processing unit may determine the latency period based on the first clock generator, in particular depending on a first clock signal generated by the first clock generator.

That the first and the second clock generator are synchronized with respect to each of may for example be understood such that the first clock signal is generated in a synchronized manner with respect to the second clock signal or vice versa.

For example, the motion compensation system, in particular the image processing unit, and the MRI scanner, in particular the processing unit and/or the control unit, may exchange one or more synchronization signals in order to carry out the synchronization.

According to several implementations, the processing unit is configured to estimate the compensated position of the object at the acquisition time based on the determined position at the recording time, the latency period and an additional latency period.

The additional latency period may for example comprise a time shift between the clock signals.

Alternatively or in addition, the additional latency period may comprise a time required for data transmission from the motion compensation system to the processing unit.

According to several implementations, the MRI scanner, in particular the control unit and/or the processing unit, and the motion compensation system, in particular the image processing unit, are connected to each of via a bus system, in particular via a serial peripheral interface, SPI, bus. The synchronization is carried out, for example, via the bus system.

In case of an SPI bus, the control unit or the processing unit may act as a master unit and the motion compensation system, in particular the image processing unit, may act as a slave unit.

According to the improved concept, also a method for MRI is provided. MR data is acquired at an acquisition time by using an MRI scanner. A position of an object located in a field of view of the MRI scanner at a recording time is determined, in particular by a motion compensation system. An MR image is generated based on the MR data and based on the determined position, in particular by a processing unit. A latency period between the recording time and the acquisition time is determined, in particular by a processing unit, and the MR image is generated, in particular by the processing unit depending on the latency period.

According to several implementations, a compensated position of the object at the acquisition time is estimated, in particular by the processing unit, based on the determined position at the recording time and the latency period. The MR image is generated, in particular by the processing unit, depending on the estimated compensated position.

According to several implementations, a reference position of the object is determined, in particular prior to the recording time, and a deviation of the determined position from the reference position is extrapolated, in particular by the processing unit, to estimate the compensated position of the object.

The reference position is, for example, given by an earlier position of the object with respect to the recording time.

The reference position may also correspond to an estimated position for the object or to a fixed predetermined position.

According to several implementations, camera data depicting a camera field of view, which overlaps at least in part with the field of view of the MRI scanner, is generated, in particular by the motion compensation system, for example, by a camera system of the motion compensation system. Image data is generated based on the camera data, in particular by the motion compensation system, for example, an image processing unit of the motion compensation system, the image data comprising the recording time.

According to several implementations, position data is generated, in particular by the motion compensation system, for example, by a position calculation module of the motion compensation system, based on the image data, the position data comprising the recording time and the determined position of the object at the recording time.

According to several implementations, the position of the object at the recording time is calculated based on the image data in order to determine the position.

The MR image is, in particular, generated based on the position data.

According to several implementations, a first clock signal is generated, for example by a first clock generator of the MRI scanner. The MR data is acquired according to or depending on the first clock signal.

According to several implementations, a second clock signal is generated, for example by a second clock generator of the motion compensation system, in particular of the image processing unit. The recording time is determined and/or the image data is generated according to or depending on the second clock signal.

According to several implementations, the first clock signal for acquiring the MR data is synchronized with the second clock signal for determining the position, in particular for generating the image data and/or for determining the recording time.

In particular, the first clock signal and the second clock signal are synchronized prior to the acquisition time and prior to the recording time.

According to several implementations, the position of the object is determined by means of a marker-based object tracking method or by means of a marker-less object tracking method.

According to several implementations one or more method steps of the method according to the improved concept are carried out by a server computing system or a cloud computing system.

These method steps may, in particular, comprise steps described above with respect to the motion compensation system, in particular the image processing unit or the position calculation module, and or the processing unit.

Further implementations of the method according to the improved concept follow directly from the various implementations of the arrangement according to the improved concept and vice versa. For example, the arrangement according to the improved concept may be programmed or configured to carry out a method according to the improved concept or the arrangement carries out a method according to the improved concept.

According to the improved concept, also a computer program comprising instructions is provided. When the instructions are executed or the computer program is executed by an arrangement for MRI according to the improved concept, in particular by the processing unit of the arrangement, the instructions cause the arrangement to carry out a method according to the improved concept.

According to the improved concept, also a computer readable storage medium storing a computer program according to the improved concept is provided.

The computer program and the computer readable storage medium may both be considered as respective computer program products comprising the instructions.

In the figures,
- FIG 1: shows schematically an exemplary implementation of an arrangement for MRI according to the improved concept; and
- FIG 2: shows schematically a position of an object as a function of time.

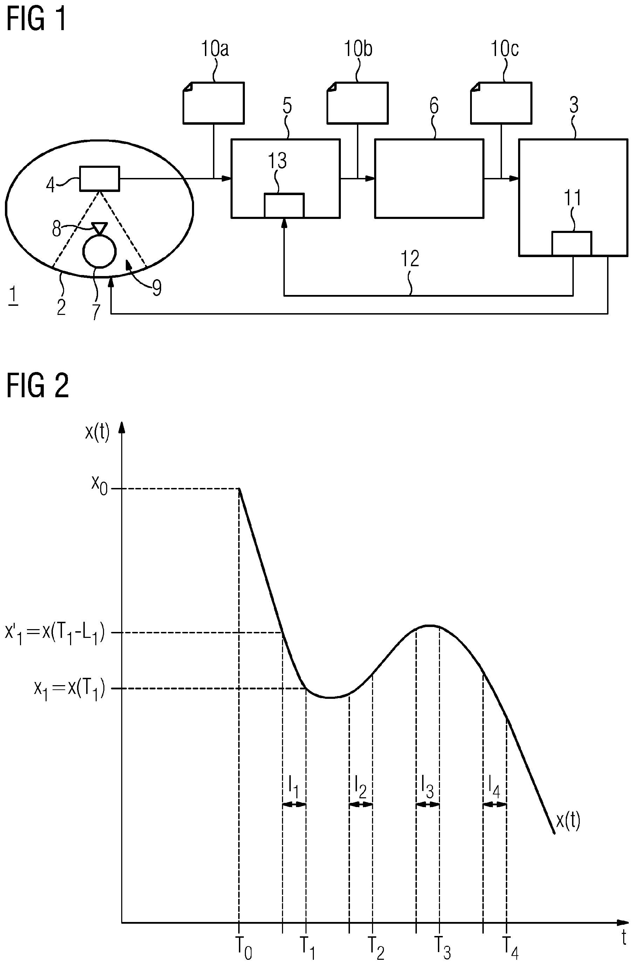

FIG 1 shows schematically an exemplary implementation of an arrangement 1 for MRI according to the improved concept.

The arrangement 1 comprises an MRI scanner 2 with a magnet arrangement according to a bore-design or another common design. The MRI scanner 2 may corresponding radio frequency coils and, for example, gradient coils.

The arrangement 1 further comprises a control and processing unit 3 coupled to the MRI scanner 2 and configured to control the MRI scanner 2 according to an MRI sequence.

The arrangement 1 further comprises a motion compensation system 4, 5, 6 with a field of view 9, so that the motion compensation system 4, 5, 6 may determine or monitor a position of an object 8 within the field of view 9.

The object 8 may, for example, correspond to a marker attached to an object 7 to be imaged, which may for example be a person.

However, in alternative implementations, the motion compensation system 4, 5, 6 may determine the position of the object 7 to be imaged directly, that is without using markers 8.

Also the MRI scanner 2 has a field of view and the field of view 9 of the motion compensation system 4, 5, 6 overlaps at least in part with the field of view of the MRI scanner 2.

The MRI scanner 2 may acquire MR data at an acquisition time T1 and the motion compensation system 4, 5, 6 may determine a position X1' of the object 8 at a recording time T1' = T1 - 11, as depicted schematically in FIG 2. FIG 2 shows a hypothetic example for the position X of the object 8 as a function of time t. For simplicity, only a one-dimensional plot is shown, while in an actual situation, the motion compensation system 4, 5, 6 determines the position X1' and other positions in three dimensions.

Due to the latency of the system, in particular the motion compensation system 4, 5, 6, which may stem from time required for determining the position X1' and transmitting the respective data from the motion compensation system 4, 5, 6 to the control and processing unit 3, the recording time T1' and the acquisition time T1 differ by a latency period 11, as shown in FIG 2.

The control and processing unit 3 may determine the latency period 11 and generate an MR image based on the MR data, the determined position X1' and the latency period 11. To this end, the control and processing unit 3 may adjust a corresponding reference coordinate frame for acquiring the MR data according to the determined position X1' and the latency period 11, in particular according to a compensated position X1 of the object 8 at the acquisition time T1.

To this end, the control and processing unit 3 may determine a reference position X0 of the object 8 at a reference time T0 and estimate the compensated position X1 of the object 8 by extrapolating a deviation between the reference position X0 and the determined position X1'.

In the same way as described with respect to the MR data, the arrangement 1 may generate sets of further MR data at respective further acquisition times T2, T3, T4.

In each case, the respective latency 12, 13, 14 is determined by the control and processing unit 3 and the corresponding position of the object 8 is determined by the motion compensation system 4, 5, 6 and corrected by calculating the corresponding compensated position at the respective acquisition time T2, T3, T4. The control and processing unit 3 is configured to generate the MR image based on the MR data, the sets of further MR data, the determined positions and the latency periods 11, 12, 13, 14, 15.

In this way, the control and processing unit 3 is able to accurately adapt the coordinate system for the acquisition continuously according to the position of the object 8 by taking into account not only the positions determined by the motion compensation system 4, 5, 6 but also the latency periods 11, 12, 13, 14.

The motion compensation system 4, 5, 6 may, for example, comprise one or more cameras 4 having the corresponding field of view 9, an image processing unit 5 and a position calculation module 6.

The image processing unit 5 may be coupled to the control and processing unit 3 via a bus system 12, in particular an SPI bus.

The control and processing unit 3 may comprise a first clock generator 11, and the image processing unit 5 may comprise a second clock generator 13. In order to compute the latency periods 11, 12, 13, 14 accurately, a first clock signal generated by the first clock generator 11 is synchronized with a second clock signal generated by the second clock generator 13.

The cameras 4 generate camera data 10a depicting the object 8 at the recording time T1'. The camera data 10a is received by the image processing unit 5.

The image processing unit 5 generates image data 10b. To this end, the camera data may or may not be processed and the camera data or the processed camera data are equipped with a time stamp corresponding to the recording time T1'. This time stamp is, in particular, synchronous with the time corresponding to the first clock signal of the first clock generator 11.

The image data 10b is provided to the position calculation module 6. The position calculation module 6 generates position data 10c based on the image data 10b, wherein the position data 10c comprises the recording time T1' and the determined position X1' of the object at the recording time T1'. In particular, the position calculation module 6 may determine the position X1' based on the image data 10b and forward the recording time T1' together with the information regarding the determined position X1' to the control and processing unit 3.

The control and processing unit 3 may apply a prediction algorithm, for example, based on extrapolation to estimate the compensated position X1 of the object 8 at the acquisition time T1 based on the position data 10c.

Then, the control and processing unit 3 may control the MRI scanner 2 to generate the MR data, wherein the respective coordinate system is adjusted depending on the estimated position X1.

The described steps are for example repeated accordingly to generate the further MR data and after a sufficient amount of data is acquired, the control and processing unit 3 may generate the MR image based on all available or required motion compensated MR data.

In alternative implementations, tasks described to be carried out by the motion compensation system 4, 5, 6, in particular the image processing unit 5 and/or the position calculation module 6, may be carried out by a server system or cloud computing system (not shown).

As described, the improved concept provides an arrangement and a method for MRI including motion compensation with an improved accuracy.

To this end, the latency necessarily attached to the position data is determined and used to further correct the motion compensation. Consequently, the improved concept allows to correct the motion of the object to be imaged with increased accuracy, therefore further reducing motion artifacts in the MR image.

Furthermore, the acquired knowledge regarding the actual latency period may also be used to check whether the maximum latency period is still met. Therefore, the improved concept may be extended to include suggestions for calibration or maintenance.

For example, an MRI experiment is carried out according to specific implementations of the improved concept, as explained in the following.

The processing unit controls the experiment, in particular the MR acquisition, for example layers, and stores the raw data. From the raw data, the MR image may be reconstructed. The motion compensation system generate position information for the object. To start the measurement the first position is used as reference position. From then on, each new excitation in the MR experiment is corrected back to the reference position using the current position. Consequently, if the object has moved away from the reference position, the next layers to be recorded are virtually shifted accordingly (prospective motion compensation). Ideally, the reconstructed MR image looks as if the object never moved away from the reference position or, in other words, the MR image shows the object in the position at the time of the reference position.

Therein, in case the latency period would be ignored, the correction would still not be completely correct, because due to the latency the used position information is already slightly outdated and the object may already be at another position. According to the improved concept and the latency correction as described above, the used correction position is improved for the next MR excitations to keep the influence of the latency of the current position data as low as possible or even eliminate it.

### Reference signs

- 1: arrangement for MRI
- 2: MRI scanner
- 3: control and processing unit
- 4: cameras
- 5: image processing unit
- 6: position calculation module
- 7: object
- 8: object
- 9: field of view
- 10a: camera data
- 10b: image data
- 10c: position data
- 11: clock generator
- 12: bus system
- 13: clock generator
- T0: reference time
- T1, T2, T3, T4: acquisition times
- X1, X1': positions
- l1, l2, l3, l4: latency periods

## Claims

1. Arrangement for magnetic resonance imaging, MRI, comprising
- an MRI scanner (2), configured to acquire magnetic resonance, MR, data at an acquisition time (T1);
- a motion compensation system (4, 5, 6), configured and arranged to determine a position (X1') of an object (8) located in a field of view of the MRI scanner (2) at a recording time; and
- a processing unit (3), configured to generate an MR image based on the MR data and the determined position (X1'); and
**characterized in that**
- the processing unit (3) is configured to determine a latency period (11) between the recording time and the acquisition time (T1); and
- the processing unit (3) is configured to generate the MR image depending on the latency period (11).

2. Arrangement according to claim 1,
**characterized in that**
the processing unit (3) is configured to
- estimate a compensated position (X1) of the object (8) at the acquisition time (T1) based on the determined position (X1') at the recording time and the latency period (11); and
- generate the MR image depending on the estimated compensated position (X1).

3. Arrangement according to one of the preceding claims,
**characterized in that**
- the MRI scanner (2) is configured to acquire further MR data at a further acquisition time (T2);
- the motion compensation system (4, 5, 6) is configured to determine a further position (X2') of the object (8) at a further recording time;
- the processing unit (3) is configured to determine a further latency period (12) between the further recording time and the further acquisition time (T2); and
- the processing unit (3) is configured to generate the MR image based on the further MR data and the further determined position (X2') depending on the further latency period (12).

4. Arrangement according to one of the preceding claims,
**characterized in that**
the motion compensation system (4, 5, 6) comprises a camera system (4) with a camera field of view (9), which overlaps at least in part with the field of view of the MRI scanner (2), wherein the camera system (4) is configured to generate camera data (10a) depicting the camera field of view (9).

5. Arrangement according to claim 4,
**characterized in that**
the motion compensation system (4, 5, 6) comprises an image processing unit (5), configured to generate image data (10b) based on the camera data (10a), the image data (10b) comprising the recording time.

6. Arrangement according to claim 5,
**characterized in that**
the motion compensation system (4, 5, 6) comprises a position calculation module (6), configured to generate position data (10c) based on the image data (10b), the position data (10c) comprising the recording time and the determined position (X1') of the object (8) at the recording time.

7. Arrangement according to claim 6,
**characterized in that**
the processing unit (3) is configured to generate the MR image based on the position data (10c).

8. Arrangement according to one of the preceding claims,
**characterized in that**
- the MRI scanner (2) comprises a first clock generator (11);
- the motion compensation system (4, 5, 6) comprises a second clock generator (13);
- the second clock generator (13) is synchronized to the first clock generator (11) or vice versa.

9. Method for magnetic resonance imaging, MRI, wherein
- magnetic resonance, MR, data is acquired at an acquisition time (T1) by using an MRI scanner (2);
- a position (X1') of an object (8) located in a field of view of the MRI scanner (2) at a recording time is determined; and
- an MR image is generated based on the MR data and the determined position (X1'); and
**characterized in that**
- a latency period (11) between the recording time and the acquisition time (T1) is determined; and
- the MR image is generated depending on the latency period (l1).

10. Method according to claim 9,
**characterized in that**
- a compensated position (X1) of the object (8) at the acquisition time (T1) is estimated based on the determined position (X1') at the recording time and the latency period (11); and
- the MR image is generated depending on the estimated compensated position (X1).

11. Method according to claim 10,
**characterized in that**
a reference position of the object (8) is determined and a deviation of the determined position (X1') from the reference position is extrapolated to estimate the compensated position of the object (8).

12. Method according to one of claims 9 to 11,
**characterized in that**
- camera data (10a) depicting a camera field of view (9), which overlaps at least in part with the field of view of the MRI scanner (2), is generated; and
- image data (10b) is generated based on the camera data (10a), the image data (10b) comprising the recording time.

13. Method according to claim 12,
**characterized in that**
position data (10c) is generated based on the image data (10b), the position data (10c) comprising the recording time and the determined position (X1') of the object (8) at the recording time.

14. Method according to one of claims 9 to 13,
**characterized in that**
a first clock signal for acquiring the MR data is synchronized with a second clock signal for determining the position (X1') .

15. Computer program product comprising instructions, which, when executed by an arrangement (1) for MRI according to one of claims 1 to 8, cause the arrangement (1) to carry out a method according to one of claim 9 to 14.
